# EUROPEAN PATENT APPLICATION

(11) **EP 4 844 486 A1**
(43) Date of publication of application: **25.11.2026**
(21) Application number: 25178330.4
(22) Date of filing: 22.05.2025
(51) Int. Cl.: G03F 7/00, G03F 9/00

(54) **METHOD OF DETERMINING A MEASUREMENT SET OF METROLOGY POINT LOCATIONS, ASSOCIATED APPARATUS AND COMPUTER PROGRAM**

(71) Applicant: ASML Netherlands B.V., 5500 AH Veldhoven (NL)
(72) Inventor: HULSEBOS, Edo, Maria, 5500 AH Veldhoven (NL); ROOZE, Joost, 5500 AH Veldhoven (NL); RAAIJMAKERS, Youri, 5500 AH Veldhoven (NL); MAYANK, Mayank, 5500 AH Veldhoven (NL)
(74) Representative: ASML Netherlands B.V.

(57) **Abstract**

Disclosed is a method of determining a measurement set of metrology point locations from a plurality of potential metrology point locations on a substrate, comprising: obtaining a candidate set of potential metrology point locations; determining whether a number of the potential metrology point locations of the candidate set should be modified based on at least a change in a performance parameter of a lithographic process and a change in a total measurement time associated with the candidate set, both changes resulting from a potential change in the number of the potential metrology point locations of the candidate set; updating the candidate set by modifying the number of the potential metrology point locations of the candidate set according to the determination; and using the updated candidate set of potential metrology point locations as the measurement set of metrology point locations.

## Description

### FIELD

The present invention relates to a method of determining a measurement set of metrology point locations from a plurality of potential metrology point locations on a substrate, an associated apparatus and a computer program.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Whichever type of apparatus is employed, the accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

Consequently, modem lithography apparatuses involve extensive measurement or 'mapping' operations prior to the step of actually exposing or otherwise patterning the substrate at a target location. These operations, being time-consuming, limit the throughput of the lithography apparatus, and consequently increase the unit cost of the semiconductor or other products.

As pattern features become smaller and overlay performance requirements become ever more demanding, so-called advanced alignment models have been and continue to be developed to model and correct more accurately non-linear distortions of the wafer 'grid'. These advanced models depend on measuring an increased number of targets across the wafer. Ultimately, however only a limited number of the available targets can be measured without unduly limiting the throughput and/or costs of the lithographic process as a whole.

### SUMMARY

In a first aspect of the invention there is provided a method of determining a measurement set of metrology point locations from a plurality of potential metrology point locations on a substrate, and the method comprising: obtaining a candidate set of potential metrology point locations; determining whether a number of the potential metrology point locations of the candidate set should be modified based on at least a change in a performance parameter of a lithographic process and a change in a total measurement time associated with the candidate set, both changes resulting from a potential change in the number of the potential metrology point locations of the candidate set; updating the candidate set by modifying the number of the potential metrology point locations of the candidate set according to the determination; and using the updated candidate set of potential metrology point locations as the measurement set of metrology point locations.

In a second aspect of the invention, there is provided a computer program operable to perform the method of the first aspect.

In other aspects of the invention, there is provided a bonding apparatus or an inspection apparatus or a metrology apparatus comprising a processing arrangement operable to perform the method of the first aspect.

These and other features and advantages of particular embodiments of the invention will be understood by the skilled reader from a consideration of the exemplary embodiments discussed below.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a schematic overview of a lithographic apparatus;
Figure 2 depicts a schematic overview of a lithographic cell;
Figure 3 illustrates schematically the stages in the measurement and exposure processes in the apparatus of Figure 1, according to known practice;
Figure 4 shows a flowchart of the proposed method of determining a measurement set of metrology point locations from a plurality of potential metrology point locations, in accordance with an embodiment;
Figure 5 shows a flowchart of a method of determining a potential metrology point location should be added to a candidate set of potential metrology point locations, in accordance with an embodiment;
Figure 6 shows a flowchart of a method of determining a potential metrology point location should be removed from a candidate set of potential metrology point locations, in accordance with an embodiment; and
Figures 7A to 7D show an example implementation of the proposed method for determining an optimal sampling scheme and an optimal sampling route based on a plurality of alignment marks on a substrate.

### DETAILED DESCRIPTION OF EXEMPLARY EMBODIMENTS

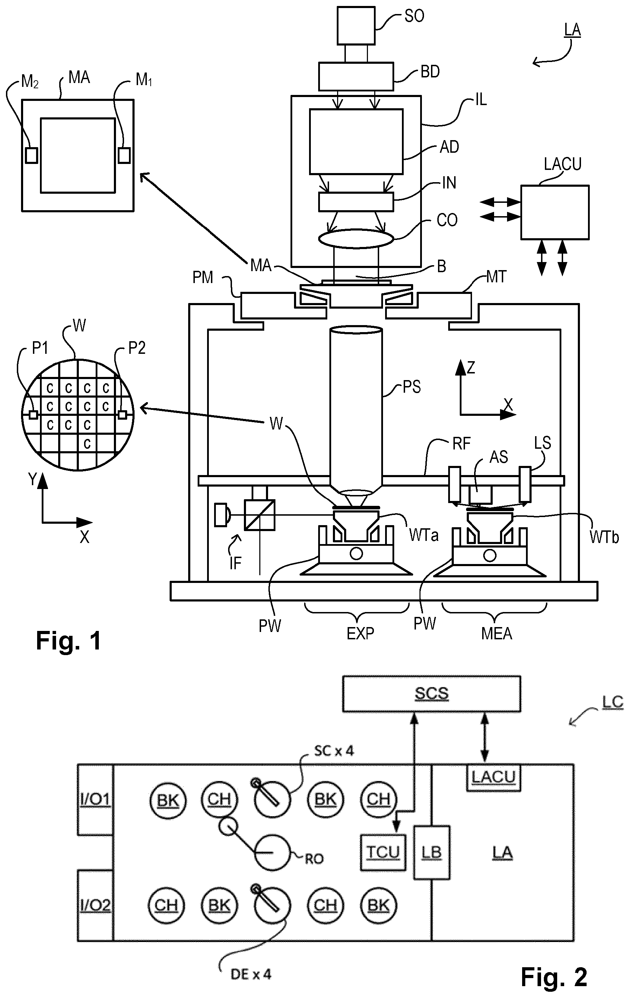

Figure 1 schematically depicts a lithographic apparatus LA according to one embodiment of the invention. The apparatus comprises:
- an illumination system (illuminator) IL configured to condition a radiation beam B (e.g. UV radiation or EUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WTa or WTb constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure. The invention disclosed herein can be used in a stand-alone fashion, but in particular it can provide additional functions in the pre-exposure measurement stage of either single- or multi-stage apparatuses.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WTa/WTb are kept essentially stationary, while an entire pattern imparted to the radiation beam is projected onto a target portion C at one time (i.e. a single static exposure). The substrate table WTa/WTb is then shifted in the X and/or Y direction so that a different target portion C can be exposed. In step mode, the maximum size of the exposure field limits the size of the target portion C imaged in a single static exposure.
2. In scan mode, the mask table MT and the substrate table WTa/WTb are scanned synchronously while a pattern imparted to the radiation beam is projected onto a target portion C (i.e. a single dynamic exposure). The velocity and direction of the substrate table WTa/WTb relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WTa/WTb is moved or scanned while a pattern imparted to the radiation beam is projected onto a target portion C. In this mode, generally a pulsed radiation source is employed and the programmable patterning device is updated as required after each movement of the substrate table WTa/WTb or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Lithographic apparatus LA in this example is of a so-called dual stage type which has two substrate tables WTa and WTb and two stations - an exposure station and a measurement station-between which the substrate tables can be exchanged. While one substrate on one substrate table is being exposed at the exposure station EXP, another substrate can be loaded onto the other substrate table at the measurement station MEA so that various preparatory steps may be carried out. The preparatory steps may include mapping the surface of the substrate using a level sensor LS and measuring the position of alignment mark on the substrate using an alignment sensor AS. This enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. The invention can be applied in apparatus with only one substrate table, or with more than two.

The apparatus further includes a lithographic apparatus control unit LACU which controls all the movements and measurements of the various actuators and sensors described. LACU also includes signal processing and data processing capacity to implement desired calculations relevant to the operation of the apparatus. In practice, control unit LACU will be realized as a system of many subunits, each handling the real-time data acquisition, processing and control of a subsystem or component within the apparatus. For example, one processing subsystem may be dedicated to servo control of the substrate positioner PW. Separate units may even handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

As shown in Figure 2, the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell LC, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools. Different types of metrology tools for making such measurements are known, including scanning electron microscopes or various forms of scatterometer metrology tools. Scatterometers are versatile instruments which allow measurements of the parameters of a lithographic process by having a sensor in or close to the pupil or a conjugate plane with the pupil of the objective of the scatterometer, measurements usually referred as pupil based measurements, or by having the sensor in or close to an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray (HXR), soft X-ray (SXR), extreme ultraviolet (EUV), visible to near-infrared (IR) and IR wavelength range. In case that the radiation is hard X-ray or soft X-ray, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer is a spectroscopic scatterometer. In such spectroscopic scatterometer, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer, the scatterometer is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for overlay error between the two layers containing periodic structures as target measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after other manufacturing process, etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the angles of incidence of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

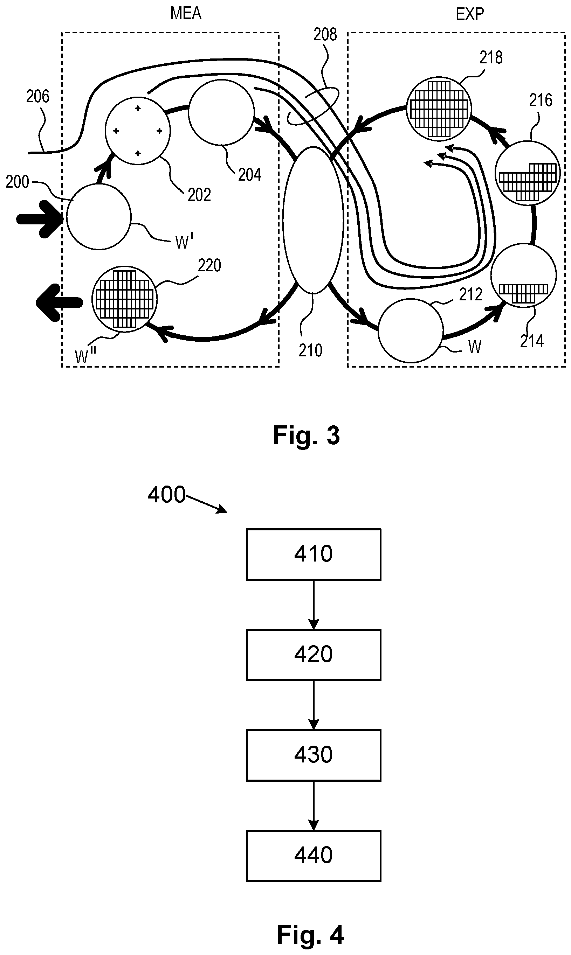

Figure 3 illustrates the known steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus. Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured, to establish a "wafer grid", which maps very accurately the distribution of marks across the substrate, including any distortion relative to a nominal rectangular grid. At step 204, a map of wafer height against X-Y position is measured also, for use in accurate focusing of the exposed pattern.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure stage. The measurements of alignment data for example comprise X and Y positions of alignment targets formed in a fixed or nominally fixed relationship to the product patterns that are the product of the lithographic process. These alignment data, taken just before exposure, are combined and interpolated to provide parameters of an alignment model. These parameters and the alignment model will be used during the exposure operation to correct positions of patterns applied in the current lithographic step. A conventional alignment model might comprise four, five or six parameters, together defining translation, rotation and scaling of the 'ideal' grid, in different dimensions. As described further below, advanced models are known that use more parameters.

At 210, wafers W' and W are swapped, so that the measured substrate W' becomes the substrate W entering the exposure station EXP. This swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns. By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The concepts disclosed herein will mainly be described in the context of overlay metrology and/or alignment metrology. However, this must not be taken as a limitation to such contexts; the concepts herein are applicable to any metrology, using a multiple sensor setup, of a proper subset of multiple potential measurement points. In any such context, a sampling scheme optimization to determine the proper subset can be expected to provide a benefit. Therefore, while alignment models will now be described for purposes of exemplary illustration, the concepts disclosed herein can also be used, for example, with exposure-dose correction models, and/or with focus correction models. Such models are well known to the skilled person and will not be described in any detail.

### Advanced Alignment Models

Basic alignment models may have six parameters (effectively three per direction X & Y) with more advanced alignment models comprising many more parameters. For more demanding processes, to achieve the desired overlay performance requires more detailed corrections of the wafer grid and advanced alignment models have been developed for this purpose. In this text, 'advanced' alignment models refers to all type of models with more complexity than the standard six parameters. While standard models might use fewer than ten parameters, advanced alignment models typically use more than 15 parameters, or more than 30 parameters. Examples of advanced models are higher order wafer alignment (HOWA) models, zone-alignment (ZA) and radial basis function (RBF) based alignment models. HOWA is a published technique based on third and higher order polynomial functions. Zone alignment is described for example in Huang et al, "Overlay improvement by zone alignment strategy", Proc. SPIE 6922, 69221G (2008), which is incorporated herein by reference. Different versions and extensions of these advanced models can be devised. The advanced models generate a complex description of the wafer grid that is corrected for, during the exposure of the target layer. RBF and latest versions of HOWA provide particularly complex descriptions based on tens of parameters. This implies a great many measurements are required to obtain a wafer grid with sufficient detail.

Even in embodiments with multiple substrate tables WTa/WTb, the time taken to obtain sufficient measurements for advanced alignment on each wafer eventually impacts throughput. Reducing the time per measurement tends to decrease the accuracy of each measurement, so that the impact on throughput is hard to avoid. In addition, once corrections have been applied in one layer using an advanced alignment model, the same level of detail should be applied in subsequent layers, or the corrections in the first layer become a source of error in the overlay of subsequent layers. The manufacturer therefore has a difficult choice whether to accept further measurement overhead by using the advanced model in subsequent layers, or to suffer an overlay penalty by reverting to a simpler alignment model in subsequent layers, measuring fewer marks.

There is a large degree of similarity in the problems faced for alignment and model estimation / correction calculation. The commonality is that a certain systematic pattern is estimated using a limited set of measurements taken at certain locations. The positions from which measurements are selected for inclusion in the estimation process, determines how reliable the resulting model is. This is because not all measurement positions are necessarily equally informative for the estimation procedure.

Some HVM (High Volume Manufacturing) measurement schemes sample a couple of fields on the substrate densely while covering the rest of the substrate in a sparse fashion (e.g. one metrology point per field). This is already suboptimal for the more basic models, and more serious problems begin to occur for higher order models. This applies to metrology performed for alignment (e.g., using an alignment sensor to align the substrate with respect to projection optics prior to exposure) and post-exposure metrology for process monitoring.

**In** a lithographic apparatus such as shown in Figure 1, alignment is performed for each substrate prior to exposure. Multiple metrology points (e.g., alignment marks) are used to capture the shape of the substrate and to average out placement noise (e.g., originating from the lithographic apparatus baseline). Additionally, to monitor the process and determine corrections therefor as part of a process control arrangement, a post-exposure metrology tool (e.g., a scatterometry based tool or e-beam tool) may be used to measure a parameter of interest (e.g., overlay, focus, critical dimension or any other metric) from multiple metrology points (e.g., metrology targets). In each case, several measurement targets may be placed in each field on the wafer. To limit the cost of metrology only a subset of these possible measurement locations are actually measured and used as input for a control algorithm that determines from these measurements the appropriate stage position and/or other exposure parameters (e.g., focus dose etc.) and corrections (over the field, over the wafer, over the lot) for the lithographic exposure system or other processing equipment.

Some current algorithms for determining which metrology locations are sampled from a set of candidate measurement locations (e.g., in the context of alignment metrology, overlay metrology, focus metrology, dose metrology, contrast metrology or other metrology of structures, targets or marks formed by a lithographic process) attempt to sample the substrate in a uniform fashion, uniformity being defined as being equal distances between neighboring metrology locations. This is sometimes referred to as equidistance mark selection (EMS). Such a method may be implemented as a greedy strategy (i.e., once selected, locations cannot then be unselected). Locations may be selected individually from the available candidate locations at each selection step. The selected location may be assessed as the next most valuable metrology location according to a distance metric (i.e., maximizing distance from already selected locations).

A variation on such an approach may use the distance metric to determine a subset of the candidate locations which are distant from already selected locations, followed by a step of choosing a single location from the subset based on a normalized model uncertainty metric.

For example, WO2015/110191 (which is incorporated herein by reference) describes methods for determining a measurement scheme or sampling scheme (e.g., describing which metrology locations are to be measured from all available metrology locations), which may be referred to as sample scheme optimization (SSO). Such a method comprises evaluating candidate metrology locations; for example, to determine how much the informativity of the sample scheme would improve if that metrology location were selected. This may comprise evaluating all candidate metrology locations and selecting the one which is determined will add the most information for the measurement scheme. More specifically, each selected metrology location may have an associated exclusion zone around it and candidate locations may comprise only potential metrology locations located outside of these exclusion zones. This ensures that the overall sampling scheme is distributed sufficiently over the substrate.

Present methods such as those described above do not simultaneously optimize the sampling scheme (or layout) and the sampling route. Instead, a sampling scheme optimization is first performed to select or determine a measurement set of metrology point locations (e.g., alignment mark locations) from a plurality of potential metrology point locations provided on a substrate that are to be measured by a metrology tool (e.g., an alignment sensor arrangement). Once the measurement set of metrology points is determined, a sampling route optimization will then be performed to determine an optimal route for measuring the measurement set of metrology points. Here, a sampling route refers to a specific path along which the selected metrology point locations are sequentially measured. The 3-opt and integer linear programming (ILP) are two known methods that are often used to determine an optimal route for measuring a subset of selected metrology points.

In the context of alignment metrology, separately optimizing the sampling scheme with a fixed number of alignment marks and the sampling route within a given wafer alignment measurement time often results in sub-optimal results and thus further improvements are still possible. This issue is also present in post-exposure metrology and inspection where a set of metrology targets is selected and subsequently sampled to determine a performance parameter of a lithographic process. It is possible to fully optimize the sampling scheme and the sampling route within a given wafer alignment measurement time through a full co-optimization of the sampling scheme (with a varying number of alignment marks) and the sampling route. However, such an approach is computationally intensive, and it is problematic to include routing aspects into existing sampling scheme optimization methods. Therefore, it is the object of the present disclosure to at least mitigate the issues associated with the prior art.

Accordingly, an aspect of the present disclosure provides a method of determining a measurement set of metrology point locations from a plurality of potential metrology point locations on a substrate. A typical total number of potential metrology point locations on a substrate may be in the region of 250-1000 although other different numbers may also be possible. In an example implementation, the measurement set comprises at least 3 metrology point locations. When used for wafer alignment, the proposed method not only allows a sampling scheme and a sampling route to be fully optimized within a given wafer alignment measurement time but also ensures that the optimization process is performed in a less computationally intensive manner.

The proposed determining whether a number of the potential metrology point locations of the candidate set should be modified based on at least a change in a performance parameter of a lithographic process and a change in a total measurement time associated with the candidate set, both changes resulting from adding or removing a potential metrology point location to or from the candidate set; updating the candidate set by modifying the number of the potential metrology point locations of the candidate set according to the determination; and using the updated candidate set of potential metrology point locations as the measurement set of metrology point locations.

With reference to Figure 4, the proposed method 400 may comprise for example four main steps, i.e. 410-440.

Step 410 may comprise obtaining a candidate set of potential metrology point locations. The potential metrology point locations may be locations of a plurality of alignment marks distributed across the substrate. In some example implementations, each of the alignment marks may be a bidirectional mark (or mark pair) comprising a x-direction mark and a y-direction mark. In alternative example implementations, each of the alignment marks may be a unidirectional mark. The candidate set may comprise at least one of the potential metrology point locations on the substrate. Preferably, the number (e.g., 50-80) of the potential metrology point locations comprised within the candidate set is (significantly) smaller than the total number (e.g., 250-1000) of the potential metrology point locations provided on the substrate. However, it is also possible that the candidate set may comprise all the potential metrology point locations provided on the substrate. The candidate set of potential metrology point locations may be predetermined e.g., based on empirical data. Alternatively, the candidate set of potential metrology point locations may be randomly generated.

Step 420 may comprise determining whether a number of the potential metrology point locations of the candidate set should be modified based on at least a change in a performance parameter of a lithographic process and a change in a total measurement time associated with the candidate set, both changes resulting from adding or removing a potential metrology point location to or from the candidate set. The performance parameter of the lithographic process may comprise, for example, an overlay error of the substrate, and/or an edge placement error (EPE) of the substrate, and/or a critical dimension (CD) of the substrate. The performance parameter may be a single parameter or a combination of multiple parameters. For example, in an embodiment, the performance parameter may be overlay measured in a first direction (e.g., X-axis overlay) while in a different embodiment the performance parameter may be the combination of overlay measured in a first direction (e.g., X-axis overlay) and overlay measured in a second direction (e.g., Y-axis overlay). The total measurement time may be the time a metrology tool (e.g., an alignment system) takes to measure all the potential metrology point locations comprised within the candidate set. Modifying a number of the potential metrology point locations of the candidate set comprises adding one or more potential metrology point locations to the candidate set or removing one or more potential metrology point locations from the candidate set.

In the case of alignment metrology (e.g., performed by an alignment sensor), adding a potential metrology point location to the candidate set may increase the total measurement time but at the same time may improve the quality of the exposure or other subsequent IC manufacturing process such as bonding, whereas removing a potential metrology point location from the candidate set may decrease the total measurement time but at the same time may deteriorate the quality of the exposure. In the case of post-exposure metrology or inspection (e.g., performed by a metrology tool or an inspection tool), adding a potential metrology point location to the candidate set may increase the total measurement time but at the same time may decrease the overlay error or the EPE measured in the feature, whereas removing a potential metrology point location from the candidate set may decrease the total measurement time but at the same time may increase the overlay error or the EPE measured in the feature.

In an embodiment, a change in the performance parameter of the lithographic process may be determined or estimated using existing estimation models (e.g., alignment models). For example, when a potential metrology point location is added to or removed from the candidate set, all the potential metrology points of the candidate set may be measured and the resultant measurement data may be fitted with an estimation model which may have been trained to estimate a value of the performance parameter of the lithographic process. The change in the performance parameter may be indicated by the difference between a newly estimated value and a previously estimated value of the performance parameter.

In an example implementation, a change in the overlay of the lithographic process may be determined using Woodbury matrix identity. It is known that Woodbury matrix identity allows cheap computation of inverses and solutions to linear equations. Further information about the Woodbury matrix identity can be found in the publication, Max A. Woodbury, "Inverting modified matrices", Volume 42 of Memorandum Report, Statistical Research Group, Princeton University, Princeton, New Jersey, 1950, 4pp., MR0038136, which is incorporated herein by reference. The Woodbury matrix identity is expressed as: ${\left(A+UCV\right)}^{- 1} = {A}^{- 1} - {A}^{- 1} U {\left({C}^{- 1}+{VA}^{- 1}U\right)}^{- 1} {VA}^{- 1} ,$ [1] where *A, U, C* and *V* are conformable matrices: *A* is *n*×*n, C* is *k*×*k, U* is *n*×*k,* and *V* is *k*×*n.* The Woodbury matrix identity allows a perturbed matrix, e.g., *C* to be computed for a change to a given matrix, e.g., *A.*

The Woodbury matrix identity based method enables efficient updating of the alignment model and overlay residuals when adding or removing one or more metrology point locations. The method is computationally much cheaper than remodeling and applying the model to overlay every time. The following matrices are used as input to the model:
*M:* the alignment model (or design) matrix. This matrix contains the model functions evaluated at the alignment mark locations. The size of the matrix is the number of measurements times the number of model parameters. Note that the *x* and *y* measurements are stacked on top of each other.
*Mₒᵥₗ*: the overlay model (or design) matrix. This matrix has the same model parameters (i.e. matrix columns) as the alignment model matrix but it usually has many more overlay measurements (i.e. matrix rows).
*S*: the model subspace matrix. In some cases, only a subspace (or subset) of the model may be used. For example, in the case of the RBF based model, the RBF constraint may be implemented as a subspace matrix. The size of the matrix is the number of model parameters times the number of subspace dimensions.
*R*: the regularization matrix. Some models (such as HOWA and RBF) may use (bending energy) regularization. For the RBF based model, at least some (e.g., ~10⁻⁶ or ~10⁻⁹) bending energy regularization may be required for the method to work correctly. This is a square symmetric positive semidefinite matrix with size equal to the number of model parameters.
*X*: the alignment position deviation (APD) data (which evaluates the difference between the actually measured position and the nominal (or design) position of the alignment mark). The size of this matrix is the number of alignment measurements times the number of wafers.
*Y*: the de-corrected overlay data. The size of this matrix is the number of overlay measurements times the number of wafers.

From the above input matrices, a set of four initial matrices (or Woodbury matrices) can be calculated. Such four initial or Woodbury matrices are described as follows.

The first matrix is alignment hat matrix *H* which is expressed as: $H = MS {\left({S}^{T}{M}^{T}MS+{S}^{T}RS\right)}^{- 1} {S}^{T} {M}^{T} .$ [2] This matrix performs modeling and evaluation on the alignment grid. The modeling includes subspace and regularization here, which may be omitted from the equation if not used. Note that the mathematical expression in equation [2] may not be the most accurate way to calculate the hat matrix, as it involves taking the square of the model matrix and calculating the inverse matrix. To get a numerically more stable result, the hat matrix may be calculated by using an LDL decomposition (which is a closely related variant of the classical Cholesky decomposition and is expressed as *A = LDL^{T},* where *A* is a Hermitian positive-definite matrix, *L* is a lower unit triangular matrix, *D* is a diagonal matrix, and *L^{T}* is the transpose of the lower unit triangular matrix *L*)) for the regularization matrix and a Singular Value Decomposition of the design matrix.

The second matrix is overlay hat matrix *Hₒᵥₗ* which is expressed as: ${H}_{ovl} = {M}_{ovl} S {\left({S}^{T}{M}^{T}MS+{S}^{T}RS\right)}^{- 1} {S}^{T} {M}^{T} .$ [3] This matrix performs modeling on the alignment grid and evaluation on the overlay grid. The modeling again includes subspace and regularization here, which may be omitted from the equation if not used. Similar to the alignment hat matrix, the mathematical expression in equation [3] may not be the most accurate way to calculate the overlay hat matrix. To get a numerically more stable result, the overlay hat matrix may be calculated using an LDL decomposition for the regularization matrix and Singular Value Decomposition of the design matrix.

The third matrix is alignment residual matrix R which is expressed as: $R = X - HX .$ [4] The alignment residual matrix contains the alignment residuals after applying the fitted alignment model.

The fourth matrix is overlay residual matrix *Rₒᵥₗ* which is expressed as: ${R}_{ovl} = Y - {H}_{ovl} X .$ [5] The overlay residual matrix contains the overlay residuals after applying the fitted alignment model.

The above-described four Woodbury matrices (i.e. as expressed in equations [2]-[5]) are all that are needed for calculating the resultant overlay or alignment residuals so as to determine a change in the performance parameter when one or more metrology point locations are added or removed.

Several considerations may be taken into account when implementing this method. First, the four Woodbury matrices may initially contain all available metrology point locations. After removing one or more metrology point locations, the sizes of these four matrices may still match with the total number of available metrology point locations. The removal of one or more metrology point locations may be implemented by changing the values of the corresponding matrix elements rather than by removing rows or columns from these matrices. Secondly, it may require keeping track on which metrology point locations are removed or added. When removing a metrology point location that has already been removed or adding a metrology point location that is already there, the matrices may give incorrect results. It may be possible to remove a metrology point location and add it back later. Thirdly, if the regularization matrix is to be changed (e.g., by changing the regularization factor), the four Woodbury matrices may need to be recalculated from scratch as this may not be done via the Woodbury updates.

The following equations [6]-[9] may be used for updating the Woodbury matrices in the case of removing one or more metrology point locations: ${R}_{ovl} = {R}_{ovl} + {\left[{H}_{ovl}\right]}^{r} {\left({I}_{r}-{\left[H\right]}_{r}^{r}\right)}^{- 1} {\left[R\right]}_{r} ,$ [6] $R = R + {\left[H\right]}^{r} {\left({I}_{r}-{\left[H\right]}_{r}^{r}\right)}^{- 1} \left[{R}_{r}\right] ,$ [7] ${H}_{ovl} = {H}_{ovl} + {\left[{H}_{ovl}\right]}^{r} {\left({I}_{r}-{\left[H\right]}_{r}^{r}\right)}^{- 1} {\left[H\right]}_{r} ,$ [8] $H = H + {\left[H\right]}^{r} {\left({I}_{r}-{\left[H\right]}_{r}^{r}\right)}^{- 1} {\left[H\right]}_{r} .$ [9] The following equations [10]-[13] may be used for updating the Woodbury matrices in the case of adding one or more metrology point locations: ${R}_{ovl} = {R}_{ovl} - {\left[{H}_{ovl}\right]}^{a} {\left({I}_{a}+{\left[H\right]}_{a}^{a}\right)}^{- 1} {\left[R\right]}_{a} ,$ [10] $R = R - {\left[H\right]}^{a} {\left({I}_{a}+{\left[H\right]}_{a}^{a}\right)}^{- 1} {\left[R\right]}_{a} ,$ [11] ${H}_{ovl} = {H}_{ovl} - {\left[{H}_{ovl}\right]}^{a} {\left({I}_{a}+{\left[H\right]}_{a}^{a}\right)}^{- 1} {\left[H\right]}_{a} ,$ [12] $H = H - {\left[H\right]}^{a} {\left({I}_{a}+{\left[H\right]}_{a}^{a}\right)}^{- 1} {\left[H\right]}_{a} .$ [13]

In equations [6]-[13], mark removal index *r* is an array of integers, which specifies which metrology point locations to remove or add and matches to row numbers of the alignment model matrix. If a mark pair is to be removed (in the case where the metrology points are bidirectional alignment marks), the array will contain two items: one for the *x* measurement and one for the y measurement of the mark pair. Mark removal index *r* may have any length such that multiple metrology point locations may be removed at once. Similar to mark removal index *r,* mark adding index *a* is an array of integers which specifies which metrology point locations to add and matches to row numbers of the alignment model matrix. If a mark pair is to be added (in the case where the metrology points are bidirectional alignment marks), the array will contain two items: one for the *x* measurement and one for the *y* measurement of the mark pair. Mark adding index *a* may have any length such that multiple metrology point locations may be added at once.

Furthermore, a bracket notation with subscripts and superscripts is used in equations [6]-[13] to specify row and column selection. For example, row selection [*H*]*ᵣ* is a smaller matrix that contains only the rows from matrix *H* that are specified by mark removal index *r.* Column selection [*H*]*^{r}* is a smaller matrix that contains only the columns from matrix *H* that are specified by mark removal index *r.* Combined row and column selection ${\left[H\right]}_{r}^{r}$ is a smaller matrix that contains only the rows and columns from matrix *H* that are specified by mark removal index *r.* The same applies to other matrices as well as the case of adding one or more metrology point locations.

Whenever one or more metrology point locations are added or removed, overlay residual matrix *Rₒᵥₗ* is the first one to be updated to calculate the overlay impact. Only when the best potential metrology point location is selected or determined, the other three matrices, i.e. *R, Hₒᵥₗ, H,* will then be updated.

Note that in equations [6]-[9] or equations [10]-[13], the inverse matrix, i.e. ${\left({I}_{r}-{\left[H\right]}_{r}^{r}\right)}^{- 1}$ or ${\left({I}_{a}+{\left[H\right]}_{a}^{a}\right)}^{- 1}$*,* is identical for all four matrix updates. So it only needs to be calculated once. The size of the inverse matrix is equal to the number of measurements to be added or removed. For example, in the case where the metrology points are bidirectional alignment marks each comprising a x-direction mark and a y-direction mark, the inverse matrix is a 2-by-2 matrix, which makes the inverse and the matrix multiplications very cheap. Also note that the order in which these four matrices are updated is crucial, as the result of a matrix update depends on the other matrices. The correct order is given in the above equations, i.e. equations [6]-[13].

A change in the total measurement time may be determined using existing routing optimization methods. For example, after a potential metrology point location is added to or removed from the candidate set, a routing optimization may be performed on the potential metrology points of the updated candidate set to determine an optimal sampling route for measuring all the potential metrology point locations. The optimal sampling route may then be used to determine the total measurement time, which may also take account of factors like types of the metrology points, scan speed and scan direction at each metrology point location, wafer stage settling time, etc. The change in the total measurement time may be indicated by the difference between a newly determined total measurement time and a previously determined total measurement time.

In an embodiment, the determination that a potential metrology point location should be added to the candidate set may be made if the addition of the potential metrology point location results in an improvement on the performance parameter per unit of an increased amount of the total measurement time (e.g., an increase in overlay or EPE per second of an increased amount of the total measurement time).

In an embodiment, the determination that a potential metrology point location should be removed from the candidate set may be made if the removal of the potential metrology point location results in a deterioration on the performance parameter per unit of a decreased amount of the total measurement time (e.g., a decrease in overlay or EPE per second of a decreased amount of the total measurement time).

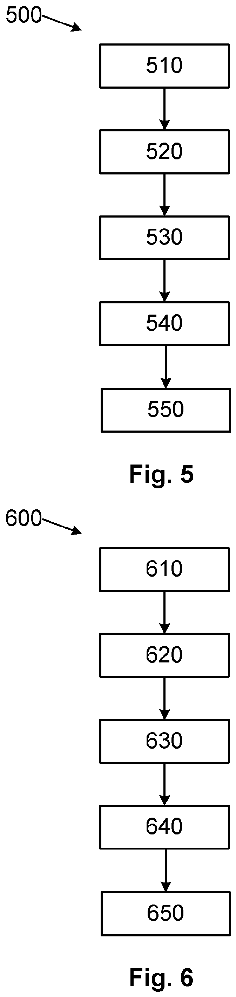

With reference to Figure 5, whether a potential metrology point location should be added to the candidate set may be determined by performing the method 400 comprising the following five main steps, i.e. steps 510-550.

Step 510 may comprise determining a first value of the performance parameter of the lithographic process and a first amount of the total measurement time for the candidate set.

Step 520 may comprise for each potential metrology point location not comprised in the candidate set, determining, for the candidate set, a second value of the performance parameter of the lithographic process and a second amount of the total measurement time after assuming the corresponding potential metrology point location is added to the candidate set.

Step 530 may comprise for each potential metrology point location not comprised in the candidate set, determining, for the candidate set, an amount of performance improvement on the performance parameter based on the first value and the second value of the performance parameter, and an increased amount of the total measurement time based on the first amount and the second amount of the total measurement time.

Step 540 may comprise for each potential metrology point location not comprised in the candidate set, determining a performance improvement rate by calculating a ratio of the amount of performance improvement on the performance parameter over the increased amount of the total measurement time. The performance improvement rate may be, for example, an increase in overlay or EPE per second, or a decrease in overlay or EPE per second.

Step 550 may comprise determining to add a potential metrology point location to the candidate set if its corresponding performance improvement rate is the highest among the potential metrology point locations not comprised in the candidate set.

The method 500 may be performed either before or during the performance of step 420 of determining whether a number of the potential metrology point locations of the candidate set should be modified.

With reference to Figure 6, whether a potential metrology point location should be removed from the candidate set may be determined by performing the method 600 comprising the following five main steps, i.e. steps 610-650.

Step 610 may comprise determining a first value of the performance parameter of the lithographic process and a first amount of the total measurement time for the candidate set.

Step 620 may comprise for each potential metrology point location comprised in the candidate set, determining, for the candidate set, a third value of the performance parameter of the lithographic process and a third amount of the total measurement time after assuming the corresponding potential metrology point location is removed from the candidate set.

Step 630 may comprise for each potential metrology point location comprised in the candidate set, determining, for the candidate set, an amount of performance deterioration on the performance parameter based on the first value and the third value of the performance parameter, and a decreased amount of the total measurement time based on the first amount and the third amount of the total measurement time.

Step 640 may comprise for each potential metrology point location comprised in the candidate set, determining a performance deterioration rate by calculating a ratio of the amount of performance deterioration on the performance parameter over the decreased amount of the total measurement time.

Step 650 may comprise determining to remove a potential metrology point location from the candidate set if its corresponding performance deterioration rate is the lowest among the potential metrology point locations comprised in the candidate set.

The method 600 may be performed either before or during the performance of step 420 of determining whether a number of the potential metrology point locations of the candidate set should be modified.

The proposed method is not only suitable for the case of adding or removing a single potential metrology point location, but also equally applicable to the case of adding or removing two or more potential metrology point locations at each time.

When adding multiple potential metrology point locations to the candidate set, a performance improvement on the performance parameter and an increased amount of the total measurement time may be determined for each subset of potential metrology point locations not comprised within the candidate set, wherein said subset comprises a desired number of potential metrology point locations to be added at once to the candidate set. Then, similar to method steps 540 and 550, for each subset of potential metrology point locations not comprised in the candidate set, a performance improvement rate may be determined by calculating a ratio of the amount of performance improvement on the performance parameter over the increased amount of the total measurement time, and a potential metrology point location may be added to the candidate set if its corresponding performance improvement rate is the highest among the potential metrology point locations not comprised in the candidate set.

When removing multiple potential metrology point locations from the candidate set, a performance deterioration on the performance parameter and a decreased amount of the total measurement time may be determined for each subset of potential metrology point locations of the candidate set, wherein said subset comprises a desired number of potential metrology point locations to be removed at once from the candidate set. Then, similar to method steps 640 and 650, for each subset of potential metrology point locations of the candidate set, a performance deterioration rate may be determined by calculating a ratio of the amount of performance deterioration on the performance parameter over the decreased amount of the total measurement time, and a potential metrology point location may be added to the candidate set if its corresponding performance deterioration rate is the lowest among the potential metrology point locations of the candidate set.

It will be appreciated that instead of determining a change in the performance parameter and a change in the total measurement time during the co-optimization process, at least some of such information associated with each potential metrology point location either comprised or not comprised within the candidate set may be predetermined, i.e. determined before commencement of the co-optimization process. The information associated with each potential metrology point location may be achieved in a similar manner as achieved during the co-optimization process.

Accordingly, in an embodiment, the proposed method 400 may further comprise for each potential metrology point location on the substrate, obtaining a change in the performance parameter of a lithographic process and a change in the total measurement time associated with the candidate set after assuming the corresponding potential metrology point location is added to or removed from the candidate set. Said obtaining a change in the performance parameter may comprise obtaining a predetermined amount of performance improvement on the performance parameter after assuming the corresponding potential metrology point location is added to the candidate set, and/or a predetermined amount of performance deterioration on the performance parameter after assuming the corresponding potential metrology point location is removed from the candidate set. Said obtaining a change in the total measurement time may comprise obtaining a predetermined increased amount of the total measurement after assuming the corresponding potential metrology point location is added to the candidate set, and/or a predetermined decreased amount of the total measurement time after assuming the corresponding potential metrology point location is removed from the candidate set.

The predetermined information may be contained in a pre-configuration data file which may be stored in a memory (e.g., a memory of the lithographic apparatus shown in Figure 1). Whenever the proposed method is performed, a processing arrangement may access the stored pre-configuration data file to retrieve the relevant information about each potential metrology point location on the substrate.

In an embodiment, the pre-configuration data file may comprise a pre-calculated routing time matrix containing a plurality of time coefficients, each indicating how long a metrology tool (e.g., an alignment sensor) takes to move from one metrology point location (e.g., one alignment mark) to another metrology point location (e.g., alignment mark) including settling time and scan/measurement time. As such, the total measurement time for a given sampling route may be calculated by adding up the corresponding time coefficients of the routing time matrix. If only one scan direction (i.e. positive or negative scan direction) is used, only one routing time matrix may be needed. However, if both scan directions (i.e. positive and negative scan directions) are used, four routing time matrices may then be required in order to calculate all possible total measurement times. Other information (e.g., a change in the performance parameter) that is not contained in the pre-configuration data file may be determined during the co-optimization process.

Note that the concept of the proposed method may be equally applicable in the case where the metrology points are measured by an image-based metrology or inspection tool (e.g., image-based alignment sensor). Instead of scanning over a mark (e.g., in a given direction and with a constant velocity), an image-based metrology tool may stand still above the mark and take a picture of the mark. Such a picture may then be processed to obtain measurement data.

In an embodiment, the pre-configuration data file may comprise a predetermined performance improvement rate and a predetermined performance deterioration rate for each potential metrology point location on the substrate. Thus, either before or during the performance of step 420, the processing arrangement may access the pre-configuration data file to retrieve the predetermined performance improvement rates and/or the predetermined performance deterioration rates for the potential metrology point locations comprised or not comprised within the candidate set. Then, the processing arrangement may compare the performance improvement rates for all the potential metrology point locations that are not comprised within the candidate set to determine a potential metrology point location having the highest predetermined performance improvement rate, or may compare all the performance deterioration rates that are comprised within the candidate set to determine the lowest predetermined performance deterioration rate. Finally, the processing arrangement may add or remove the determined potential metrology point location to or from the candidate set.

The time for determining a change in the total measurement time may be reduced if such a change is determined without performing a full routing optimization (e.g., the 3-opt or ILP method) when a potential metrology point location is added to or removed from the candidate set. The fast determination of a change in the total measurement time may be achieved by keeping the current sampling route (e.g., sampling order and scan orientation) substantially the same.

In the case of removing a metrology point location from the candidate set, the simplified determination process may comprise determining a change in the total measurement time for each potential metrology point location of the candidate set, assuming the sampling order and the scan orientation (if applicable) of the other potential metrology point locations of the candidate set are kept the same. The determined change in the total measurement time may then be used for determining a performance deterioration rate based on which a potential metrology point location may be removed (as described above).

In the case of adding a metrology point location to the candidate set, the simplified determination process may comprise searching, for each of the potential metrology point locations that are not comprised within the candidate set, the best position or order (and if applicable the best scan orientation) in the sampling sequence to add the potential metrology point location, assuming the sampling order and the scan orientation (if applicable) of the existing potential metrology point locations of the candidate set the same; and determining a change in the total measurement time for each potential metrology point location at the corresponding best position in the sampling sequence.

Step 430 may comprise updating the candidate set by modifying the number of the potential metrology point locations of the candidate set according to the determination. In an embodiment, the candidate set may be updated by adding or removing the potential metrology point location to or from the candidate set according to the determination.

In an embodiment, method steps 420 and 430 may be performed repetitively until one or more criteria are met. In an embodiment, the one or more criteria may comprise that a number of potential metrology point locations of the candidate set is between a low threshold number and a high threshold number. The low threshold number may be, for example, 20, 30, 40, 50, or 60 and the high threshold number may be, for example, 120, 110, 100, 90, or 80.

Preferably, the number of the candidate set of potential metrology point locations may be modified in a predefined manner.

In an embodiment, the process of removing potential metrology point locations from the candidate set may only be performed after a certain number of potential metrology point locations have been added to the candidate set. This may be achieved by adding one potential metrology point location at a time for multiple times until the number of potential metrology point locations of the candidate set reaches a high threshold number. Then, a certain number of potential metrology point locations may be removed from the candidate set. This may be achieved by removing one potential metrology point location at a time for multiple times until the number of the potential metrology point locations of the candidate set reaches a low threshold number.

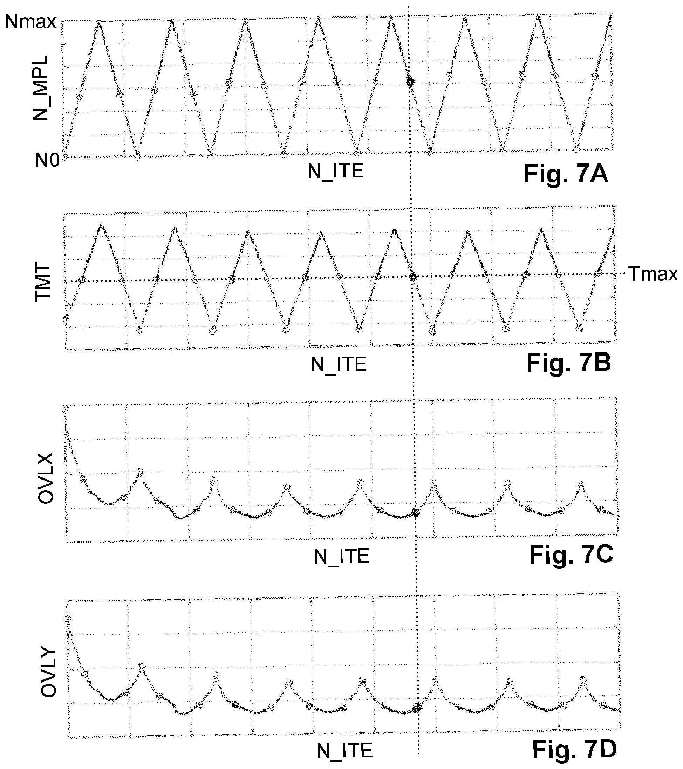

Figures 7A-7D are plots of data generated while the sampling scheme and sampling route are being optimized in a predefined manner. Specifically, Figure 7A is a plot of the number N_MPL of the potential metrology point locations of the candidate set against the iteration number N_ITE and Figure 7B is a plot of the corresponding total measurement time TMT against the iteration number N_ITE. Figures 7C and 7D are two plots of the estimated X-axis overlay OVLX and the estimated Y-axis overlay OVLY against the iteration number N_ITE. At each iteration of the optimization, a potential metrology point location is added to or removed from the candidate set.

With reference to Figure 7A, in this example implementation, removing a potential metrology point location is only performed after a predefined number of potential metrology point locations have been added into the candidate set. In other words, the number N_MPL of the potential metrology point locations of the candidate set continuously increases (by one metrology point location per iteration) from an initial number N0 to a maximum number Nmax and then continuously decreases (by one metrology point location per iteration) from the maximum number Nmax back to the initial number N0.

With reference to Figure 7B, at each iteration (i.e. when a potential metrology point location is added to or removed from the candidate set), the current candidate set of potential metrology point locations is used to determine a new total measurement time TMT (e.g., using the above-mentioned method), which is compared to a maximum total measurement time Tmax: if the new total measurement time TMT is higher than the maximum total measurement time Tmax, it is represented by a dark-gray dot; if the new total measurement time TMT is lower than the maximum total measurement time Tmax, it is represented by a light-gray dot; if the new total measurement time TMT is equal to the maximum total measurement time Tmax, it is represented by an empty circle.

The data points (i.e. N_MPL, OVLX, OVLY) of the plots shown in Figures 7A, 7C and 7D are marked in the same manner: the data points associated with a total measurement time TMT higher than the maximum total measurement time Tmax are represented by dark-gray dots, the data points associated with a total measurement time TMT lower than the maximum total measurement time Tmax are represented by light-gray dots, and the data points associated with a total measurement time TMT equal to the maximum total measurement Tmax are represented by empty circles. Note that in all the plots shown in Figures 7A-7D, the data points associated with the initial candidate set of potential metrology point locations are represented by empty circles.

With reference to Figures 7C and 7D, at each iteration, in addition to determining a new total measurement time TMT, the current candidate set of potential metrology point locations is also used to determine a new X-axis overlay value OVLX and a new Y-axis overlay value OVLY (e.g., using the above-mentioned method). After a certain number of iterations of optimization have been performed, the iteration that resulted in a total measurement time not higher than the maximum total measurement time Tmax and at the same time a lowest X-axis overlay value and/or a lowest Y-axis overlay value will be determined to be the optimal iteration. The sampling scheme and the sampling route determined at such an iteration will be selected as the optimal sampling scheme and sampling route.

In the case where a modelling hyperparameter (e.g., a model regularization factor) is used (e.g., for HOWA, RBF), the optimization of the sampling scheme and sampling route may simultaneously lead to an optimized modelling hyperparameter. Note that modelling hyperparameters may impact overlay performance and affect the optimal layout of metrology points.

In an alternative embodiment, the process of adding potential metrology point locations to the candidate set may only be performed after a certain number of potential metrology point locations have been removed from the candidate set (e.g., which comprises all the potential metrology point locations on the substrate). This may be achieved by removing one potential metrology point location at a time for multiple times until the number of potential metrology point locations of the candidate set reaches a low threshold number. Then, a certain number of potential metrology point locations may be added to the candidate set. This may be achieved by adding one potential metrology point location at a time for multiple times until the number of the potential metrology point locations of the candidate set reaches a high threshold number.

Step 440 may comprise using the updated candidate set of potential metrology point locations as the measurement set of metrology point locations.

A different aspect of the present disclosure provides a computer program comprising program instructions operable to perform the proposed method, when run on a suitable apparatus (e.g., a computing resource). The computer program may be stored in a non-transient computer program carrier which may be comprised in a processing apparatus. The processing apparatus may be part of a lithographic apparatus or a substrate bonding apparatus.

Other aspects of the present disclosure include a bonding apparatus or an inspection apparatus or a metrology apparatus comprising a processing arrangement operable to perform the proposed method as described above, and a lithographic apparatus comprising a patterning device support for supporting a patterning device, a substrate support for supporting a substrate, and the inspection apparatus, and/or the metrology apparatus, and/or the bonding apparatus.

The following numbered examples may demonstrate one or more aspects of the present disclosure.

Example 1:a method of determining a measurement set of metrology point locations from a plurality of potential metrology point locations on a substrate, and the method comprising: obtaining a candidate set of potential metrology point locations; determining whether a number of the potential metrology point locations of the candidate set should be modified based on at least a change in a performance parameter of a lithographic process and a change in a total measurement time associated with the candidate set, both changes resulting from a potential change in the number of the potential metrology point locations of the candidate set; updating the candidate set by modifying the number of the potential metrology point locations of the candidate set according to the determination; and using the updated candidate set of potential metrology point locations as the measurement set of metrology point locations.

Example 2:a method as defined in example 1, wherein modifying a number of the potential metrology point locations of the candidate set comprises adding a potential metrology point location to the candidate set or removing a potential metrology point location from the candidate set, and wherein the potential change in the number of the potential metrology point locations of the candidate set comprises a potential addition or a potential removal of a potential metrology point location to or from the candidate set.

Example 3:a method as defined in example 2, wherein the candidate set is updated by adding or removing the potential metrology point location to or from the candidate set according to the determination.

Example 4:a method as defined in example 2 or 3, wherein the determination that a potential metrology point location should be added to the candidate set is made if the addition of the potential metrology point location results in an improvement on the performance parameter per unit of an increased amount of the total measurement time.

Example 5:a method as defined in example 2 or 3 or 4, wherein the determination that a potential metrology point location should be removed from the candidate set is made if the removal of the potential metrology point location results in a deterioration on the performance parameter per unit of a decreased amount of the total measurement time.

Example 6:a method as defined in example 4 or 5, further comprising determining a first value of the performance parameter of the lithographic process and a first amount of the total measurement time for the candidate set.

Example 7: a method as defined in example 6, further comprising for each potential metrology point location not comprised in the candidate set, determining a second value of the performance parameter of the lithographic process and a second amount of the total measurement time for the candidate set after a potential addition of the corresponding potential metrology point location to the candidate set.

Example 8:a method as defined in example 7, further comprising for each potential metrology point location not comprised in the candidate set, determining an amount of performance improvement on the performance parameter based on the first value and the second value of the performance parameter, and an increased amount of the total measurement time based on the first amount and the second amount of the total measurement time for the candidate set after a potential addition of the corresponding potential metrology point location to the candidate set.

Example 9:a method as defined in example 8, further comprising for each potential metrology point location not comprised in the candidate set, determining a performance improvement rate by calculating a ratio of the amount of performance improvement on the performance parameter over the increased amount of the total measurement time.

Example 10: a method as defined in example 9, wherein a potential metrology point location should be added to the candidate set if its corresponding performance improvement rate is the highest among the potential metrology point locations not comprised in the candidate set.

Example 11: a method as defined in any of examples 6 to 10, further comprising for each potential metrology point location comprised in the candidate set, determining a third value of the performance parameter of the lithographic process and a third amount of the total measurement time for the candidate set after a potential removal of the corresponding potential metrology point location from the candidate set.

Example 12: a method as defined in example 11, further comprising for each potential metrology point location comprised in the candidate set, determining an amount of performance deterioration on the performance parameter based on the first value and the third value of the performance parameter, and a decreased amount of the total measurement time based on the first amount and the third amount of the total measurement time for the candidate set after a potential removal of the corresponding potential metrology point location from the candidate set.

Example 13: a method as defined in example 12, further comprising for each potential metrology point location comprised in the candidate set, determining a performance deterioration rate by calculating a ratio of the amount of performance deterioration on the performance parameter over the decreased amount of the total measurement time.

Example 14: a method as defined in example 13, wherein a potential metrology point location should be removed from the candidate set if its corresponding performance deterioration rate is the lowest among the potential metrology point locations comprised in the candidate set.

Example 15: a method as defined in any of examples 1 to 14, further comprising for each potential metrology point location on the substrate, obtaining a change in the performance parameter of a lithographic process and a change in the total measurement time associated with the candidate set after a potential addition or a potential removal of the corresponding potential metrology point location to or from the candidate set.

Example 16: a method as defined in example 15, wherein for each potential metrology point location on the substrate, obtaining a change in the performance parameter comprises obtaining a predetermined amount of performance improvement on the performance parameter after assuming the corresponding potential metrology point location is added to the candidate set, and/or a predetermined amount of performance deterioration on the performance parameter after assuming the corresponding potential metrology point location is removed from the candidate set.

Example 17: a method as defined in any of examples 1 to 16, wherein for each potential metrology point location on the substrate, obtaining a change in the total measurement time comprises obtaining a predetermined increased amount of the total measurement after assuming the corresponding potential metrology point location is added to the candidate set, and/or a predetermined decreased amount of the total measurement time after assuming the corresponding potential metrology point location is removed from the candidate set.

Example 18: a method as defined in any of examples 1 to 17, wherein the step of determining whether a number of the potential metrology point locations of the candidate set should be modified and the step of updating the candidate set are performed repetitively until one or more criteria are met.

Example 19: a method as defined in example 18, wherein the one or more criteria comprises the measurement set comprises a number of metrology point locations which is no more than a threshold number.

Example 20: a method as defined in any of examples 1 to 19, wherein the potential metrology point locations on the substrate are locations of a plurality of alignment marks on the substrate.

Example 21: a method as defined in any of examples 1 to 20, wherein the total measurement time is time that a metrology apparatus takes to measure all the potential metrology point locations comprised within the candidate set.

Example 22: a method as defined in example 21, wherein the metrology apparatus is an alignment sensor arrangement or a scatterometer, such as a dark-field scatterometer .

Example 23: a method as defined in any of examples 1 to 22, wherein the performance parameter of the lithographic process comprises overlay, and/or edge placement error, and/or critical dimension of the substrate.

Example 24: a method as defined in any of examples 1 to 23, wherein a change in the performance parameter of the lithographic process is determined using Woodbury matrix identity.

Example 25: a method as defined in any of examples 1 to 24, wherein the total measurement time for the candidate set of potential metrology point locations is determined using a full route optimization technique.

Example 26: a method as defined in example 25, wherein the full route optimization technique is either 3-opt or integer linear programming (ILP).

Example 27: a method as defined in any of examples 1 to 26, wherein the removal of a potential metrology point location is only performed after having added a certain number of potential metrology point locations to the candidate set.

Example 28: a method as defined in any of examples 1 to 27, wherein the candidate set comprises all the potential metrology point locations on the substrate.

Example 29: a computer program comprising program instructions operable to perform the method of any of examples 1 to 28, when run on a suitable apparatus.

Example 30: a bonding apparatus, comprising a processing arrangement operable to perform the method of any of examples 1 to 28.

Example 31: an inspection apparatus, comprising a processing arrangement operable to perform the method of any of examples 1 to 28.

Example 32: a metrology apparatus, comprising a processing arrangement operable to perform the method of any of examples 1 to 28.

Example 33: a metrology apparatus as defined in example 32, comprising an alignment sensor arrangement.

Example 34: a lithographic apparatus comprising: a patterning device support for supporting a patterning device; a substrate support for supporting a substrate; and the bonding apparatus of example 30, and/or the inspection apparatus of example 31, and/or the metrology apparatus of example 32 or 33.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "field"/"die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below. In addition, it should be appreciated that structural features or method steps shown or described in any one embodiment herein can be used in other embodiments as well.

## Claims

1. A method of determining a measurement set of metrology point locations from a plurality of potential metrology point locations on a substrate, and the method comprising:
obtaining a candidate set of potential metrology point locations;
determining whether a number of the potential metrology point locations of the candidate set should be modified based on at least a change in a performance parameter of a lithographic process and a change in a total measurement time associated with the candidate set, both changes resulting from a potential change in the number of the potential metrology point locations of the candidate set;
updating the candidate set by modifying the number of the potential metrology point locations of the candidate set according to the determination; and
using the updated candidate set of potential metrology point locations as the measurement set of metrology point locations.

2. A method as claimed in claim 1, wherein modifying a number of the potential metrology point locations of the candidate set comprises adding a potential metrology point location to the candidate set or removing a potential metrology point location from the candidate set, and wherein the potential change in the number of the potential metrology point locations of the candidate set comprises a potential addition or a potential removal of a potential metrology point location to or from the candidate set.

3. A method as claimed in claim 2, wherein the candidate set is updated by adding or removing the potential metrology point location to or from the candidate set according to the determination.

4. A method as claimed in claim 2 or 3, wherein the determination that a potential metrology point location should be added to the candidate set is made if the addition of the potential metrology point location results in an improvement on the performance parameter per unit of an increased amount of the total measurement time; and wherein the determination that a potential metrology point location should be removed from the candidate set is made if the removal of the potential metrology point location results in a deterioration on the performance parameter per unit of a decreased amount of the total measurement time.

5. A method as claimed in claim 4, further comprising:
determining a first value of the performance parameter of the lithographic process and a first amount of the total measurement time for the candidate set;
for each potential metrology point location not comprised in the candidate set, determining a second value of the performance parameter of the lithographic process and a second amount of the total measurement time for the candidate set after a potential addition of the corresponding potential metrology point location to the candidate set;
for each potential metrology point location not comprised in the candidate set, determining an amount of performance improvement on the performance parameter based on the first value and the second value of the performance parameter, and an increased amount of the total measurement time based on the first amount and the second amount of the total measurement time for the candidate set after a potential addition of the corresponding potential metrology point location to the candidate set; and
for each potential metrology point location not comprised in the candidate set, determining a performance improvement rate by calculating a ratio of the amount of performance improvement on the performance parameter over the increased amount of the total measurement time;
wherein a potential metrology point location should be added to the candidate set if its corresponding performance improvement rate is the highest among the potential metrology point locations not comprised in the candidate set.

6. A method as claimed in claim 4 or 5, further comprising:
determining a first value of the performance parameter of the lithographic process and a first amount of the total measurement time for the candidate set;
for each potential metrology point location comprised in the candidate set, determining a third value of the performance parameter of the lithographic process and a third amount of the total measurement time for the candidate set after a potential removal of the corresponding potential metrology point location from the candidate set;
for each potential metrology point location comprised in the candidate set, determining an amount of performance deterioration on the performance parameter based on the first value and the third value of the performance parameter, and a decreased amount of the total measurement time based on the first amount and the third amount of the total measurement time for the candidate set after a potential removal of the corresponding potential metrology point location from the candidate set; and
for each potential metrology point location comprised in the candidate set, determining a performance deterioration rate by calculating a ratio of the amount of performance deterioration on the performance parameter over the decreased amount of the total measurement time;
wherein a potential metrology point location should be removed from the candidate set if its corresponding performance deterioration rate is the lowest among the potential metrology point locations comprised in the candidate set.

7. A method as claimed in any preceding claim, further comprising, for each potential metrology point location on the substrate, obtaining a predetermined amount of performance improvement on the performance parameter after assuming the corresponding potential metrology point location is added to the candidate set, and/or obtaining a predetermined amount of performance deterioration on the performance parameter after assuming the corresponding potential metrology point location is removed from the candidate set.

8. A method as claimed in in any preceding claim, further comprising, for each potential metrology point location on the substrate, obtaining a predetermined increased amount of the total measurement time after assuming the corresponding potential metrology point location is added to the candidate set, and/or obtaining a predetermined decreased amount of the total measurement time after assuming the corresponding potential metrology point location is removed from the candidate set.

9. A method as claimed in any preceding claim, wherein the step of determining whether a number of the potential metrology point locations of the candidate set should be modified and the step of updating the candidate set are performed repetitively until one or more criteria are met.

10. A method as claimed in claim 9, wherein the one or more criteria comprises the measurement set comprises a number of metrology point locations which is no more than a threshold number.

11. A method as claimed in any preceding claim, wherein the potential metrology point locations on the substrate are locations of a plurality of alignment marks on the substrate.

12. A method as claimed in any preceding claim, wherein a change in the performance parameter of the lithographic process is determined using Woodbury matrix identity.

13. A computer program comprising program instructions operable to perform the method of any of claims 1 to 12, when run on a suitable apparatus.

14. A bonding apparatus or an inspection apparatus or a metrology apparatus, comprising a processing arrangement operable to perform the method of any of claims 1 to 12.

15. A lithographic apparatus comprising:
a patterning device support for supporting a patterning device;
a substrate support for supporting a substrate; and
the metrology apparatus of claim 14.
